Europäisches Patentamt

(19) European Patent Office

Office européen des brevets

(11) Publication number: **0 168 132**

**A2**

# (12) EUROPEAN PATENT APPLICATION

(21) Application number: **85303059.1**

(22) Date of filing: **30.04.85**

(51) Int. Cl.⁴: **H 01 L 29/91**

(30) Priority: **14.05.84 US 610226**

(43) Date of publication of application:
**15.01.86 Bulletin 86/3**

(84) Designated Contracting States:
**CH DE FR GB IT LI NL**

(71) Applicant: **ENERGY CONVERSION DEVICES, INC.**
**1675 West Maple Road**
**Troy Michigan 48084(US)**

(72) Inventor: **Ovshinsky, Stanford R.**
**2700 Squirrel Road**
**Bloomfield Hills Michigan 48013(US)**

(72) Inventor: **Guha, Subhendu**
**Maple Apartments No. 17 629 West Maple Road**
**Clawson Michigan 48017(US)**

(74) Representative: **Jackson, Peter Arthur et al,**
**GILL JENNINGS & EVERY 53-64 Chancery Lane**
**London WC2A 1HN(GB)**

(54) Static field-induced semiconductor structures.

(57) A disordered multiple layer semiconductor structure including a field-inducing layer bending the energy bands of and generating an electric field in a contiguous layer of semiconductor material. Semiconductor devices incorporating the invention have improved performance resulting from increased drift length of charge carriers and increased stability. The bent energy bands and induced electric field assist the movement of charge carriers through the multiple layer semiconductor structure, improving electrical conductivity in a direction transverse to the layers.

FIG 2

ENERGY CONVERSION DEVICES, INC.          Ref: 50/2651/02

PROXIMITY DOPED SEMICONDUCTOR STRUCTURES

Numerous attempts have been made to construct synthetic periodic materials analogous to crystalline materials. For example, in U.S. Patent No. 4,261,771, the fabrication of so-called superlattice structures by molecular beam epitaxy is described. The superlattices are formed by, for instance, a periodic variation in the composition of the alternately repeating layers, typically, no more than tens of nanometers thick. That patent also discloses quasi-superlattice and non-superlattice structures. The former are comprised of epitaxially grown islands of a foreign material in otherwise homogeneously layered background material. Non-superlattice structures are an extension of quasi-superlattice structures in that the epitaxially grown islands include columns extending vertically through the homogeneously layered background material.

Vapor deposition processes also have been used to prepare layered superlattice structures. The layer thicknesses are controlled by shutters, movement of the substrate relative to the material sources, controlling the partial pressure of process gases, or combinations of these techniques.

Semiconductor materials must be doped in order to fabricate almost all types of semiconductor devices. Conventional doping of disordered semiconductor materials generally introduces additional defect states into the band gap adversely affecting transport and other electrical properties.

In a multiple layer semiconductor structure, the electronic properties of a semiconductor layer may be modified by the effect of an electric field generated in an adjacent layer or layers. Because this modification is in some aspects similar to doping, this modification is referred to as proximity doping or transfer or modulation doping. For example, a thin field-inducing layer that includes deeply trapped charge carriers will induce an electric field in a nearby body of intrinsic material. The induced electric field alters the position of the Fermi level in the intrinsic semiconductor material changing the free charge carrier concentration. This effect is equivalent to chemically doping the semiconductor material. The energy bands adjacent to the field-inducing layer/semiconductor material interface are bent, enhancing the movement of charge carriers to and from that interface. The electric field may not be induced throughout the entire bulk of the intrinsic semiconductor material. The field-inducing layer may also be created because of different relative Fermi levels positions in a field-inducing layer and an adjacent layer of intrinsic semiconductor material. In this case, charge carriers from one or both of the contiguous layers move across the interface to align the respective Fermi levels at the interface.

By using these techniques, an amorphous silicon-hydrogen alloy of an intrinsic conductivity type may be induced to behave as a n-type conductivity material by superimposing on it a relatively thin (1-10 nanometers thick) field-inducing layer, such as an amorphous silicon-nitrogen-hydrogen alloy, that contains excess fixed positive charge carriers. Since no dopant atoms are physically present in the intrinsic semiconductor layer, no additional defect states are introduced into the band gap by the proximity doping process. In a like manner, intrinsic semiconductor materials may be effectively p-doped. Proximity doping may also be employed to vary the behavior of already doped materials. For example, proximity doping may be employed to force a p-type material to behave as a heavier or lighter doped p-type layer. Photoresponsive devices semiconductor can be improved by including proximity doped multiple layer amorphous semiconductor material.

Figure 1 is a schematic illustration of the valence and conduction bands of alternating layers of intrinsic semiconductor material bent by trapped charge carriers within alternating field-inducing layers.

Figure 2 is a schematic illustration depicting the bending of the valence and conduction bands of alternating layers of intrinsic semiconductor material by charge carriers trapped in different strata of alternating dual-stratum field-inducing layers.

Figure 3 is a schematic illustration depicting the bending of the valence and conduction bands of alternating layers of intrinsic semiconductor material by alternating field-influencing strata.

Figure 4 is a schematic illustration depicting the bending of the valence and conduction bands of alternating layers of intrinsic semiconductor material by charge carriers trapped in different strata of alternating dual-stratum field-inducing layers that include a screening stratum.

Figure 5 is a cross-sectional view of a conventionally fabricated photovoltaic cell comprising successive p-i-n type conductivity layers.

Figure 6 is a cross-sectional view of a photovoltaic cell in which a layer of intrinsic semiconductor material is fabricated utilizing a three stratum field-inducing layer as illustrated in Figure 4.

Figure 7 is a cross-sectional view of a photovoltaic cell in which a layer of intrinsic semiconductor material is fabricated including a dual-stratum field-inducing layer as illustrated in Figure 3.

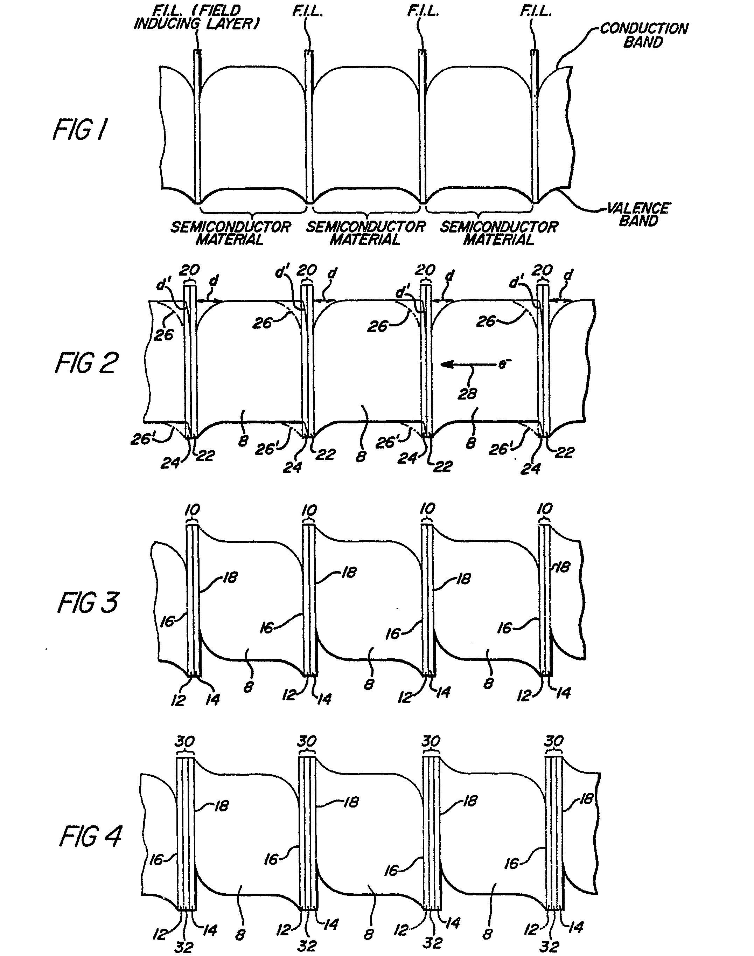

In a conventional multiple layer structure illustrated in Figure 1, a periodic field-inducing layer uniformly bends the energy bands of the periodic semiconducting downward at both sides of the field-inducing layer/field-induced layer interface. Charge carriers moving through the multiple layer structure in the direction transverse to the layers, i.e. from left to right or right to left in Figure 1, are impeded as if flowing through two p-n junctions or Schottky diodes connected back-to-back.

Figure 2 schematically depicts the valence and conduction bands of a multiple layer, proximity doped, disordered semiconductor structure fabricated in accordance with the invention. The structure includes a plurality of alternately repeating semiconductor layers 8, preferably of intrinsic conductivity, separated by field-inducing layers 20. Each field-inducing layer 20 includes a field-generating stratum 22 containing trapped charge carriers of a selected conductivity type, and a field-influencing stratum 24 containing a high density of defect states. Field-generating stratum 22 is generally similar to the amorphous silicon-hydrogen-nitrogen alloy layer described with reference to Figure 1. Field-influencing stratum 24 directs the electric field induced by layer 22. Field-influencing stratum 24 may be formed as a discrete, relatively thin (1 to 5 nanometer thick) layer of semiconductor material having a very high density of defect states in the band gap. Alternatively, field-influencing stratum 24 may be formed as a portion of intrinsic semiconductor layers 8 by incorporating dopants and/or other impurities adjacent the interface of field-inducing layer 20 and layer 8. Similarly, field-influencing stratum 24 may be formed by introducing dopant materials in field-generating stratum 22 adjacent layer 8.

In contrast to Figure 1, field-influencing stratum 24 disposed in tandem with field-generating stratum 22, asymmetrically bends the valence and conduction bands of layer 8 adjacent field-influencing stratum 24. At the interface of stratum 24 and layer 8 and, specifically, within the volume of field-influencing stratum 24, the energy bands bend downward very sharply. The energy bands of layer 8 (rather than the energy bands of field-influencing layer 24) bend more gradually at the interface of field-generating stratum 22 and intrinsic layer 8. The sharp bending of the energy bands within field-influencing stratum 24 is directly attributable to its high density of defect states. Figure 2 includes phantom lines 26 and 26' that indicate the respective conduction and energy band locations if the structure were without field-influencing strata 24. This asymmetry in the electric field increases the velocity of charge carriers moving to or from the interface of field-inducing layer 20 and semiconductor layer 8, improving the efficiency of charge carrier collection in the transverse direction of the structure. This result is obtained because the respective band edges at interfaces become aligned and the deeply trapped charge carriers in field-generating stratum 22 induce an electric field between field-generating stratum 24 and the contiguous layer of intrinsic semiconductor material 8. The electric field induces charge carriers to flow into thin field-influencing stratum 24, sharply bending the energy bands. The charge carriers flowing in the transverse direction of the structure therefore sense little resistance as they approach the interface and easily tunnel through thin field-influencing stratum 24 and field-generating stratum 22.

An electron 28 travelling through the layer 8 in the direction indicated by the arrow will first sense the induced electric field adjacent the interface of layer 8 semiconductor material and field-generating stratum 22. The electric field extends for a distance, d, into layer 8. Since electrons move to lower energy levels, the electric field promotes the movement of electron 28 toward field-inducing layer 20. Within field-influencing stratum 24, the energy bands are more sharply bent in the downward direction than in field-generating stratum 22. The electric field from stratum 24 extends only a relatively short distance, d', which is substantially limited to the thickness of field-influencing stratum 24. Therefore, electron 28 departing from the field-influencing stratum/semiconductor material interface is only subjected to the most pronounced portion of a reverse electric field for a relatively short distance. Since the extent of the field is small, the electron is able to tunnel through the field. The energy gained by electron 28 from its exposure to the accelerating electrical field in intrinsic semiconductor layer 8 is not lost by exposure to the opposing electrical field in layer 24, producing in a net acceleration. The result is an increase in the efficiency of charge carrier collection through the multiple layer semiconductor structure in the direction transverse to the layers.

A multiple layer semiconductor structure in Figure 3, similar to that of Figure 2, includes a plurality of layers of intrinsic semiconductor material 8 sandwiched between field-inducing layers 10. Field-inducing layers 10 include at least two strata, each stratum containing trapped charge carriers of one polarity, the strata containing trapped charge carriers of opposite polarity. For example, layer 8 may be formed of an amorphous silicon-hydrogen alloy and field-inducing layer 10 may include a first stratum 12 formed of an amorphous silicon-hydrogen-nitrogen alloy and a second stratum 14 formed of an amorphous silicon-hydrogen-carbon alloy. Since strata 12 and 14 respectively contain charges of opposite polarity, the energy bands of semiconductor material 8 are bent to enhance the travel of charge carriers to and from the interfaces of semiconductor layer 8 and field-inducing layer 10. The valence and conduction bands of layer 8 are bent downwardly at interface 16 of layer 8 and stratum 12, and the energy bands of layer 8 are bent upwardly at interface 18 of layer 8 with stratum 14. A charge carrier travelling in the transverse direction of a disordered multiple layer semiconductor structure that includes contiguous field-inducing layers of opposite polarities will always encounter downwardly bending energy bands when approaching interface 16. Likewise, a charge carrier of opposite conductivity type will always encounter upwardly bending energy bands adjacent opposed interface 18. Therefore, the movement of charge carriers to and from the field inducing layer 10 is enhanced by the bent energy bands. In this manner the collection of charge carriers through the transverse direction of the multiple layer proximity doped semiconductor structure of Figure 3 is enhanced.

An improved disordered multiple layer semiconductor structure, including a screening stratum 32 is depicted in Figure 4. A plurality of layers of intrinsic semiconductor material 8 is alternately sandwiched between a plurality of field-inducing layers 30. Each field-inducing layer 30 includes three strata, 12, 14 and 32. As in the embodiment of Figure 3, first field-generating stratum 12 is preferably formed of an amorphous silicon-hydrogen-nitrogen alloy. Stratum 12 induces an electric field and bends the energy bands of layer 8 at its interface with stratum 12. Field-generating stratum 14 is preferably formed of an amorphous silicon-hydrogen-carbon alloy and induces an electrical field and bends the energy bands of the layer 8 upwardly at its interface with stratum 14.

Interposed between each of the two oppositely charged field-generating strata 12 and 14 is a charge carrier-screening stratum 32. In the absence of screening stratum 32, the electric fields of opposite polarity induced by the contiguous field-generating strata 12 and 14, tend to encourage recombination, reducing the enhanced efficiency of the structure. Screening stratum 32 directs the electric fields induced by strata 12 and 14 in the desired direction. To be effective, screening layer 32 must be formed of a material capable of providing a large density of free charge carriers, exhibiting a high degree of electrical conductivity, and, in photosensitive devices, exhibiting high light transmissivity. The free charge carriers provided by the screening layer 32 promote "recombination" with the free charge carriers in field-generating strata 12 and 14 to direct the electric field induced by those strata. "Recombination" of charge carriers, as that term is employed to explain movement of charge carriers to and from the Figure 4 interfaces is not the same as the "recombination" referred to with respect to Figure 3. In the structure of Figure 3, the free charge carriers recombine reducing the effects of the induced electric field. In contrast, in the structure of Figure 4, the screening layer can be thought of as terminating one cell of a tandem device and beginning the next cell of the device. As with intermediate junctions in tandem devices, the recombination that occurs at the junction does not prevent charge carriers from contributing to the collection efficiency of the device. Rather, the charge carriers collected in the field generating strata of the invention (as with the layers of opposite conductivity in each cell of the tandem device) continue to move through the multiple layers for final collection. For amorphous silicon semiconductor alloys, similar to those amorphous semiconductor alloys previously described, an areal free charge carrier density of approximately $10^{13}$ free charge carriers per $cm^2$ is required to effect the requisite degree of recombination. However, the density of charge carriers will vary in relation to the particular material and configuration of multiple layer structures employed. It should be noted that the requisite charge carrier density of $10^{13}$ free charge carriers per square centimeter of screening layer material is readily achieved by utilizing materials such as metals or highly degenerate semiconductor alloys. However, use of metals is not preferred in photovoltaic applications since metallic layers inherently absorb portions of the solar spectrum that are more desirably utilized in the active semiconductor material. Screening strata formed of metallic alloys may be employed for non-illuminated semiconductor devices, or for photovoltaic applications where the non-productive light absorption in the metallic alloy is not a significant concern. In most photovoltaic applications, however, it is necessary that screening stratum 32 be relatively transparent to illumination. For this reason, alloys, such as transparent, electrically conductive, indium tin oxide, tin oxide, highly doped amorphous silicon alloys, and other such substantially and/or highly degenerate transparent semiconductor alloy materials can be employed. It has been found that a screening stratum of approximately 1-10 nanometers in thickness is sufficient to screen the adjacent strata of opposite trapped charge carrier polarity. The screening stratum material should be highly optically transmissive when used in photosensitive devices, exhibit good electrical conductivity, and provide the requisite density of free charge carriers.

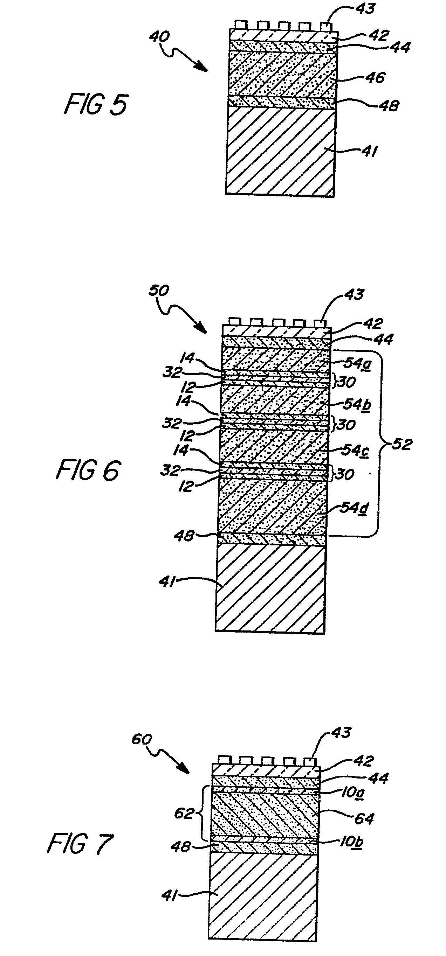

In Figure 5, a photovoltaic cell 40 is formed on a substrate 41, which, if electrically conductive, functions as a first electrode of the cell. Substrate 41 may be transparent, fabricated from a metallic material such as stainless steel, aluminum, tantalum, molybdenum or chromium, with or without an insulating layer thereon, or fabricated from an insulating material such as glass with or without embedded metallic particles. Certain applications may require that a thin conductive oxide layer and/or a thin, resistive barrier layer, and/or a series of base contacts be deposited prior to the deposition of the layers of semiconductor material. The term "substrate" therefore includes not only a flexible film, but also any elements added to it by preliminary processing.

- 12 -

Photovoltaic cell 40 is fabricated with an amorphous semiconductor alloy body containing at least a silicon alloy, germanium alloy, or a silicon-germanium alloy. Included in this cell is an n-type conductivity semiconductor layer 44, an intrinsic semiconductor layer 46 and a p-type conductivity semiconductor layer 48.

A transparent conductive oxide (TCO) layer 42, formed in the preferred embodiment of indium tin oxide, also referred to as the second electrode, is deposited on the body of the semiconductor material. A metallic pattern, in the form of an electrode grid 43, may also be applied to shorten the carrier path through the TCO and increase current collection efficiency.

Incident light passes through TCO layer 42 and wide band gap n-type layer 44 and is absorbed in intrinsic layer 46 where it generates electron-hole pairs. N-type layer 44 and p-type layer 48 establish an electric field across intrinsic layer 46, and this potential separates the electron-hole pairs formed by the incident light. Under the influence of this electric field, the free charge carriers, i.e., the electrons and the holes, migrate to the respective electrodes for collection.

Although photovoltaic cell 40 is a single p-i-n type photovoltaic cell, a plurality of p-i-n layers may be stacked to form what is generally referred to as a "tandem photovoltaic device". It is especially advantageous to employ a stacked or tandem photovoltaic device in which the first cell is formed of a wide band gap material that absorbs only the shorter wavelength of the solar spectrum, while subsequent cells utilize smaller band gap materials to absorb longer wavelengths of the solar spectrum.

An improved photovoltaic device 50 in Figure 6 has several layers in common with the conventional photovoltaic device 40 of Figure 5. Layers of devices 40 and 50 that are common in structure and operation are assigned similar reference numerals. Photovoltaic device 50 includes a substrate 41 on which is deposited a layer 48 of, for instance, p-type conductivity semiconductor material. Disposed on layer 48 is a multiple layer intrinsic semiconductor structure 52, generally similar to the structure described with reference to Figure 4. Field-inducing layers 30 are formed of two field-generating strata 12 and 14 respectively containing trapped charge of opposite polarity separated by a charge carrier-screening stratum 32. Multiple layer structure 52 replaces intrinsic layer 46 in device 40 of Figure 5. On structure 52, opposite layer 48, is a layer 44 of, for instance, n-type semiconductor material. A TCO layer 42 and a grid 43 may be included to aid in current collection. Field generating stratum 12 is formed, for example, of an amorphous silicon-hydrogen-nitrogen alloy and field-generating stratum 14 is formed, for example, of a silicon-hydrogen-carbon alloy.

As shown in Figure 6, the layers of semiconductor structure 52, are preferably deposited in progressively varying thicknesses. Structure 52 may be regarded as a stack of series-connected p-i-n type photovoltaic cells, each of which is generally similar to the single p-i-n photovoltaic device of Figure 5. It is preferable to vary the thicknesses of the layers of intrinsic semiconductor material progressively because, by substantially matching the photogenerated electrical current produced within each cell, the efficiency of the device is optimized. For example, in photovoltaic device 50 formed of an amorphous silicon alloy, a first layer of intrinsic semiconductor material 54$\underline{a}$ is approximately 10 nanometers thick; the layer of intrinsic semiconductor material 54$\underline{b}$ is approximately 20-30 nanometers thick; the layer of intrinsic semiconductor material 54$\underline{c}$ is approximately 50-60 nanometers thick; and the layer of intrinsic semiconductor material 54$\underline{d}$ is approximately 200 nanometers thick. Although only four layers of intrinsic semiconductor material, and hence only four stacked cells, are illustrated in Figure 6, a fifth cell may be added. A fifth cell would include a layer of intrinsic semiconductor material of approximately 400-500 nanometers thickness. But a 400-500 nanometer thick layer of intrinsic semiconductor material is too thick to enable the electric field induced by the field-inducing layers to prevent Staebler-Wronski degradation. A lesser number of stacked cells may be employed as long as the layers of intrinsic semiconductor material have their band gaps optimized to absorb specific wavelengths of light from the solar spectrum and the electrical current generated by each individual cell are matched.

Multiple layer semiconductor structure 52 uses a proximity doped photovoltaic body to provide a high electric field throughout a portion of layers 54. The induced field increases electrical conductivity in the direction transverse to the layers to achieve highly efficient current collection and substantially reduced degradation of the semiconductor material under illumination. The electric field induced in a portion of the bulk of the layers 54 of intrinsic semiconductor increases drift length, and therefore collection efficiency, of charge carriers.

While photovoltaic device 50 of Figure 6 is described as utilizing field-inducing layers 30 formed of three discrete strata 12, 14 and 32, the configurations of field-inducing layers described with reference to Figures 2 and 3 may alternatively be employed in the fabrication of photoresponsive devices, such as solar cells.

In Figure 7 a photovoltaic device 60 is formed on a substrate 41 that is metallic or an insulating substrate having metallic electrodes. Elements of device 60 that are similar to those already described for other devices are given the same reference numbers. A layer 48, preferably of p-type semiconductor material, is disposed on substrate 41. A multiple layer intrinsic semiconductor structure 62 is disposed on layer 48 opposite substrate 41. Structure 62 includes at least one field-inducing stratum 10 containing a selected polarity of trapped charge carriers. A layer 44, preferably of n-type semiconductor material, is disposed on structure 62. Finally, as in the photovoltaic devices described above, a layer of TCO material 42 and a grid 43 aiding current collection, are disposed sequentially on layer 44. Semiconductor structure 62 includes a layer of intrinsic semiconductor material 64 having a single field-inducing layer 10 disposed on at least one side or, as illustrated as 10a and 10b, on both sides of the structure. Each of layers 10a and 10b contains trapped charge carriers, the carriers in layer 10a being of one polarity and those in layer 10b being of the opposite polarity. Layer 10a may be, for example, an amorphous silicon-hydrogen-carbon alloy containing positive charge carriers. Layer 10b may be, for example, an amorphous silicon-hydrogen-nitrogen alloy containing negative charge carriers. As previously described, layers 10a and 10b bend the energy bands and induce a high electric field through at least a portion of the body of intrinsic semiconductor material 64, accelerating movement of the charge carriers approaching and departing the field-inducing layers.

The open circuit voltage of structures incorporating the invention is improved over conventional structures because the majority charge carriers must tunnel through the field-inducing layer, resulting in a reduction of dark electrical current.

The inventive structures may be formed from amorphous silicon hydrogen alloys, fluorinated amorphous silicon alloys, amorphous germanium alloys, amorphous silicon-germanium alloys and various combinations of these materials. Normally poor quality semiconductor alloys, such as amorphous germanium semiconductor alloys that exhibit a very high density of defect states in the band gap may be proximity doped. The proximity doping induces an electric field to increase the drift length of charge carriers. The induced electric field both delays the onset of and mitigates the effects of Staebler-Wronski degradation. The mitigation and retardation of Staebler-Wronski degradation is at least partially due to the increased drift length of charge carriers caused by the presence of the strong induced electric field. Since charge carrier collection is enhanced by the electric field, the stability of devices incorporating the invention is improved.

In a photovoltaic device, field-inducing layers will preferably be fabricated from a wide band gap amorphous material to eliminate undesirable light absorption. For other electronic applications, such as for the fabrication of transistors and the like, narrower band gap amorphous semiconductor materials may be desirably employed. Although the various field-inducing layers, and the strata from which the field-inducing layers are formed, have been illustrated as possessing sharply defined interfaces, such sharply defined interfaces are not required for the practice of the invention. The field-inducing layers may be doped in a graded manner to dispose regions of opposite conductivity uniformly at the distal ends of the layers, with the concentration of oppositely charged dopants decreasing toward the central portion of the layer. Moreover, the energy bands illustrated in Figures 1-4 are merely schematic in nature. An induced electric field may actually extend throughout the bulk of the intrinsic semiconductor material.

CLAIMS

1.    A disordered multiple layer semiconductor structure including at least one set of at least two layers, (8, 10) the first layer (8) of a set being formed of a semiconductor alloy, characterized in that the second layer (10) of the set is formed of first and second strata (12, 14), and each stratum (12, 14) contains trapped charge carriers of one net polarity for inducing an electric field in the first layer (8), said first and second strata (12, 14) containing charge carriers of net opposite polarities.

2.    The structure of claim 1 characterized in that said first stratum (12) is formed from an amorphous silicon-hydrogen-carbon alloy and said second stratum (14) is formed from an amorphous silicon-hydrogen-nitrogen alloy.

3.    The structure of claim 1 characterized in that said first layer (8) is formed of a semiconductor alloy of intrinsic conductivity type.

4.    A disordered multiple layer semiconductor structure including at least one set of at least two layers (8, 20), the first layer (8) of a set being formed of a semiconductor alloy, characterized in that the second layer (20) of the set is formed of at least first and second strata (22, 24), the first stratum (22) contains trapped charge carriers of a net first polarity for inducing an electric field in at least the first layer (8), and the second stratum (24) is formed of a material containing defect states for influencing the magnitude and direction of the induced electric field.

5. The structure of claim 4 characterized in that the second stratum (24) is disposed between the first stratum (22) and the first layer (8).

6. The structure of claims 4 or 5 characterized in that the first stratum (22) is formed as an amorphous silicon-hydrogen-carbon alloy containing trapped charge carriers of a net positive polarity.

7. The structure of claims 4 or 5 characterized in that the first stratum (22) is formed of an amorphous silicon-hydrogen-nitrogen alloy containing trapped charge carriers of a net negative polarity.

8. The structure of claim 4 characterized in that the second layer (30) is formed of at least first, second and third strata (12, 14, 32), the second stratum (14) contains trapped charge carriers of a net polarity opposite to that of the first stratum (12), and said third stratum (32) is disposed between said first and second strata (12, 14) to limit the extent of the electric fields induced by the first and second strata (12, 14).

9. The structure of claim 8 characterized in that the first layer (8) is an amorphous silicon-hydrogen alloy and the first (12) and second strata (14) are one of amorphous silicon-hydrogen-nitrogen and amorphous silicon-hydrogen-carbon alloys.

- 20 -

10. The structure of claim 9 characterized in that the second stratum (32) is formed of an electrically conductive material having an areal density of charge carriers of approximately $10^{13}$ per $cm^2$.

FIG 1

F.I.L. (FIELD INDUCING LAYER)   F.I.L.   F.I.L.   F.I.L.   CONDUCTION BAND

SEMICONDUCTOR MATERIAL   SEMICONDUCTOR MATERIAL   SEMICONDUCTOR MATERIAL   VALENCE BAND

FIG 2

FIG 3

FIG 4

0168132

212

**FIG 5**

40

43
42
44
46
48
41

**FIG 6**

50

43
42
44
14
32
12
30
54a
54b
14
32
12
30
54c
14
32
12
30
54d
52
48
41

**FIG 7**

60

43
42
44
10a
62
64
48
10b
41